Europäisches Patentamt

European Patent Office

Office européen des brevets

(11) Veröffentlichungsnummer: **0 192 063**
**A2**

(12) # EUROPÄISCHE PATENTANMELDUNG

(21) Anmeldenummer: 86100736.7

(51) Int. Cl.⁴: **G 01 R 5/14**

(22) Anmeldetag: 21.01.86

(30) Priorität: 20.02.85 DE 3505861

(43) Veröffentlichungstag der Anmeldung:
27.08.86 Patentblatt 86/35

(84) Benannte Vertragsstaaten:
DE FR GB IT SE

(71) Anmelder: VDO Adolf Schindling AG
Gräfstrasse 103
D-6000 Frankfurt/Main(DE)

(72) Erfinder: Lindig, Christian
Rossert Strasse 5a
D-6233 Kelkheim 4(DE)

(72) Erfinder: Duffait, Roland
Bremer Strasse 2-6
D-6236 Eschborn(DE)

(74) Vertreter: Klein, Thomas, Dipl.-Ing. (FH)
Sodener Strasse 9 Postfach 6140
D-6231 Schwalbach a. Ts.(DE)

(54) **Kreuzspuldrehmagnetmesswerk.**

(57) Bei einem Kreuzspuldrehmagnetmeßwerk mit einem als Wikkelkörper ausgebildeten annähernd zylindrischen Kern sind eine erste und eine zweite Spule übereinander gekreuzt aufgewickelt. Die zweite Spule ist im Bereich der Stirnseiten des Wickelkörpers zwangsläufig über der ersten Spule angeordnet und weist somit eine größere Windungshöhe als diese auf. In dem Kern ist ferner ein Drehmagnet gelagert, dessen Zeigerwelle aus einem Ansatz des Kerns herausgeführt ist. Um die Linearitätsfehler dieses Meßwerks herabzusetzen und eine Anzeige über mehrere Quadranten zu ermöglichen, sind an dem Kern abstandshaltende Mittel angeordnet, welche Windungen der Spule im Abstand zum Ansatz des Kerns um diesen in jeweils einer rechtwinkligen Ebene führen. In Verbindung damit ist der Kern im Wickelbereich der ersten Spule mit einem vergrösserten Durchmesser gestaltet, der in Beziehung zu dem Durchmesser des Wickelbereichs der zweiten Spule so bemessen ist, daß die mittleren Windungslängen beider Spulen angepaßt sind.

FIG. 1

(

VDO Adolf Schindling AG

Gräfstraße 103
6000 Frankfurt/Main

G-R Kl-kmo / 1819

19. Februar 1985

## Kreuzspuldrehmagnetmeßwerk

Die Erfindung betrifft ein Kreuzspuldrehmagnetmeßwerk nach dem Oberbegriff des Anspruchs 1.

Derartige bekannte Kreuzspuldrehmagnetmeßwerke werden für verschiedene Meß- und Anzeigezwecke eingesetzt, z.B. zur Füllstand- oder Temperaturmessung, oder aber als Voltmeter oder Amperemeter.

Die bekannten Kreuzspuldrehmagnetmeßwerke weisen einen als Wickelkörper verwendeten Kern auf, in dem der Drehmagnet drehbar gelagert ist. Aus einer Stirnseite des Kerns ragt ein Ansatz heraus, in dem die Drehmagnetwelle untergebracht ist und in die Zeigerwelle übergeht, welche aus dem Ansatz herausgeführt ist.

Es hat sich gezeigt, daß mit bekannten Kreuzspuldrehmagnetmeßwerken der eingangs genannten Gattung nur Ausschlagwinkel realisiert werden können, die wenig über 90$^0$ liegen.

Wenn bei diesen Meßwerken im wesentlichen nur der erste Quadrant ausgenutzt wird, kann durch Einstellung wenigstens eines Spannungssignals, mit dem eine der beiden Spulen beaufschlagt wird, eine Eichung auf den gewünschten Endwert des vollen Ausschlags erfolgen. - Es ist jedoch nicht ohne weiteres möglich, derartige Kreuzspuldrehmagnetmeßwerke zur Anzeige über mehrere Quadranten zu verwenden, da eine Verschiebung des Endwerts im ersten Quadranten zwangsläufig eine entgegengesetzte Verschiebung im dritten Quadranten zur Folge hat.

Zu der vorliegenden Erfindung gehört daher die Aufgabe, ein Kreuzspuldrehmagnetmeßwerk der eingangs genannten Gattung so weiterzubilden, daß dieses zur Anzeige über mehrere Quadranten, insbesondere bis zum dritten Quadranten mit genügender Genauigkeit verwendet werden kann. Schwierigkeiten durch eine Eichung mittels Einstellung eines Spannungssignals in einer Spule sollen dabei vermieden werden.

Diese Aufgabe wird durch die Ausformung des Kerns mit den im kennzeichnenden Teil des Anspruchs 1 angegebenen Merkmalen gelöst.

Durch die Kombination dieser Merkmale wird ein Linearitätsfehler des Zeigerausschlags über mehrere Quadranten wesentlich herabgesetzt, so daß eine Spannungssteuerung beider Spulen mit zwei Spannungssignalen möglich ist, deren Größtwerte gleich sind. Dadurch wird vermieden, daß durch eine Eichung im ersten Quadranten der Fehler im dritten Quadranten vergrößert wird oder umgekehrt analog.

Die als Kombinationsmerkmal vorgesehenen abstandshaltenden Mittel sind vorzugsweise als längliche Stege ausgebildet, die im zylindrischen Wandbereich des Kerns eingelassen sind und die wenigstens so breit wie der Ansatz des Kerns ist, wo die Zeigerwelle herausgeführt wird.

Mit den länglichen Stegen, die vorzugsweise in die Stirnseiten des Kerns hineinragen und an den Stirnseiten sowie über ihre Oberseiten abgerundet sind, wird eine besonders zuverlässige den Wickelvorgang nicht störende Führung des Wickeldrahts gewährleistet.

Eine Ausführungsform des erfindungsgemäßen Wickelkörpers wird im folgenden anhand der Zeichnung mit zwei Figuren beschrieben. In der Zeichnung sind dargestellt:

Figur 1   der Kern in einer Draufsicht auf die Seite, aus der der - nicht dargestellte - Ansatz herausragt, und

Figur 2   der Kern in einer Seitenansicht.

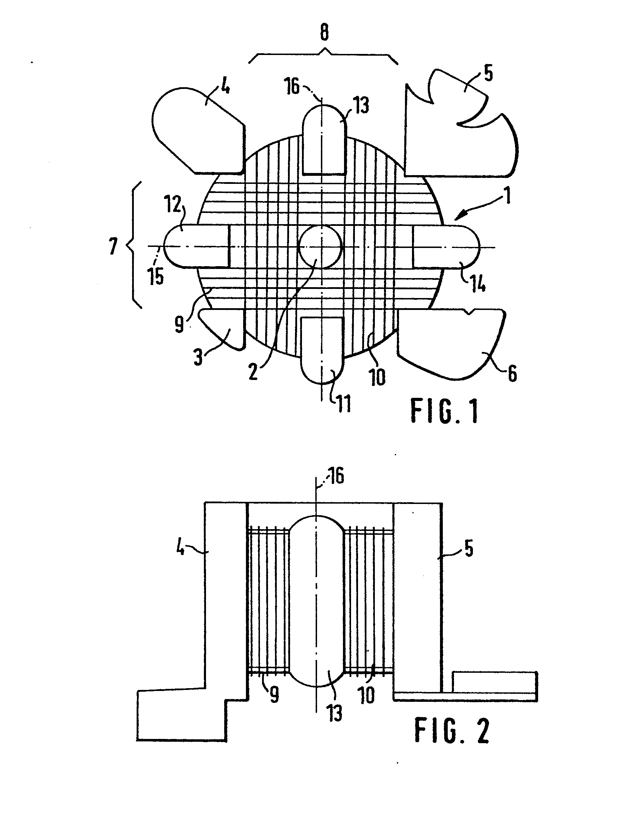

Aus Fig. 1 und 2 ist die im wesentlichen zylindrische Form des als Wickelkörper verwendeten Kerns, der allgemein mit 1 bezeichnet ist, ersichtlich. Ein nicht dargestellter Ansatz für eine ebenfalls nicht dargestellte Zeigerwelle ragt aus der Stelle 2 aus einer Stirnseite des Kerns heraus. Durch Führungselemente 3 bis 7 an der Peripherie der Zylinderform des Kerns wird dieser in zwei Wickelbereiche 7 und 8 unterteilt. Der Wickelbereich ist zum Bewickeln des Kerns mit einer ersten Spule 9 vorgesehen, über die in dem zweiten Wickelbereich eine zweite Spule 10 um $90^0$ gekreuzt gewickelt wird.

Wie in Fig. 1 angedeutet, ist der Kerndurchmesser im Wickelbereich 7 größer als im Wickelbereich 8, und zwar so, daß die größere Windungshöhe der zweiten Spule 10 gegenüber der ersten Spule 9 ausgeglichen wird, d.h. die magnetische Flußdichte beider Spulen 9 und 10 in der Wirkung auf den Drehmagneten gleich ist. Daraus ergibt sich für gleiche Signalspannungen in beiden Spulen, gleichen Windungszahlen und gleichen Drahtdurchmessern eine Wickelkörpergeometrie wie folgt:

Die Wickelkörpergeometrie muß so ausgelegt werden, daß die magnetische Flußdichte beider Spulen 9 und 10 gleich ist

$$B_{Spule\ 9} = B_{Spule\ 10} = \frac{\emptyset_9}{A_9} = \frac{\emptyset_{10}}{A_{10}}$$

Dabei ist

$B_{Spule\ 9}$      magnetische Flußdichte der Spule 9

$B_{Spule\ 10}$      magnetische Flußdichte der Spule 10

$\emptyset_9$      magnetischer Fluß Spule 9

$\emptyset_{10}$      magnetischer Fluß Spule 10

$A_9$      Querschnittsfläche des Feldes Spule 9

$A_{10}$      Querschnittsfläche des Feldes Spule 10

Da die äußere Spule 10 eine größere Querschnittsfläche umschließt als die innere Spule 9 ($A_{10} > A_9$), muß $\emptyset_{10}$ im Verhältnis der Querschnittsfläche größer werden als $\emptyset_9$.

Diese Bedingungen werden zweckmäßig erreicht, indem $A_9$ durch Vergrößern des Wickelkörpers im Wickelbereich 7 vergrößert wird. Dadurch wird der Widerstand $R_9$ der Spule 9 erhöht, wobei gleichzeitig der Strom $I_9$ in der Spule 9 abnimmt.

Damit ist das Verhältnis $\emptyset_9/A_9$ gleich dem Verhältnis $\emptyset_{10}/A_{10}$.

Auf diese Weise wird gegenüber bekannten Kreuzspuldrehmagnetmeßwerken eine um ein Vielfaches höhere Linearität der Anzeige erreicht, d.h., die Abweichung des angezeigten Meßwertes von dem Sollwert ist wesentlich geringer.

Im Zusammenhang mit den voranstehenden Maßnahmen ist ausserdem die konstruktive Maßnahme zu sehen, daß durch vier längliche Stege 11 bis 14 dafür gesorgt wird, daß die Windungen der Spulen nicht aus dem Bereich des Ansatzes an der Stelle 2 weggedrückt werden, sondern in planen rechteckigen Ebenen geführt sind. Die planen rechteckigen Ebenen schneiden gedanklich den Kern in Längsebenen außerhalb dessen gedachter zentraler Längsachse. Die länglichen Stege unterteilen jeden der beiden Wickelbereiche 7 und 8 in zwei gleich große Wickelteilbereiche. Es liegen also zur Bewicklung des Kerns um zwei Ebenen symmetrische Verhältnisse vor, und zwar zu den gedachten Mittelebenen, die einerseits durch die Stege 8 und 11 und andererseits durch die Stege 12 und 14 verlaufen. Diese Mittelebenen sind mit 15 und 16 bezeichnet.

Die an den Stirnseiten und auf ihren äußeren Oberflächen abgerundete Form der Stege 11 und 14 ergibt sich im einzelnen aus der Zeichnung. Diese Formgebung kann den Wickelvorgang erleichtern und eine Beschädigung des Drahts zusätz-lich vermeiden helfen.

I

VDO Adolf Schindling AG

Gräfstraße 103
6000 Frankfurt/Main

G-R Kl-kmo  / 1819

19. Februar 1985

## Patentansprüche

1. Kreuzspuldrehmagnetmeßwerk mit einem als Wickelkörper ausgebildeten, annähernd zylindrischen Kern, auf den eine erste und eine zweite Spule übereinander gekreuzt aufgewickelt sind, wobei die zweite Spule im Bereich der Stirnseiten des Wickelkörpers über der ersten Spule angeordnet ist und somit eine größere Windungshöhe als diese aufweist, und in dem ein Drehmagnet gelagert ist, dessen Zeigerwelle aus einem Ansatz des Kerns herausgeführt ist, dadurch gekennzeichnet, daß an dem Kern (1) abstandshaltende Mittel (Stege 11-14) angeordnet sind, welche Windungen der Spulen (9, 10) im Abstand zum Ansatz des Kerns um diesen in jeweils einer rechteckigen Ebene führen, und daß der Kern im Wickelbereich (7) der ersten Spule (2) einen in dem Maße vergrößerten Durchmesser gegenüber demjenigen eines Wickelbereichs (8) der zweiten Spule (10) aufweist, daß die magnetische Flußdichte der ersten und der zweiten Spule in ihrer Wirkung auf den Drehmagnet gleich ist.

2. Kreuzspuldrehmagnetmeßwerk nach Anspruch 1, <u>dadurch gekennzeichnet</u>, daß als abstandshaltende Mittel längliche Stege (11-14) in die zylindrischen Wandbereiche des Kerns eingelassen sind, die wenigstens so breit wie der Ansatz (Stelle 2) des Kerns ist.

FIG. 1

FIG. 2